# EUROPÄISCHE PATENTSCHRIFT

(11) **EP 2 275 512 B1**
(45) Veröffentlichungstag und Bekanntmachung des Hinweises auf die Patenterteilung: **25.07.2012**
(21) Anmeldenummer: 10190226.0
(22) Anmeldetag: 24.09.2004
(51) Int. Cl.: C09K 11/77, H01L 33/00

(54) **Grün emittierende LED**
Green-emitting LED
Diode electroluminescence émettant une lumière verte

(30) Priorität: 24.09.2003 DE 10344376
(43) Veröffentlichungstag der Anmeldung: 19.01.2011
(62) Teilanmeldung aus: 04786852.6
(73) Patentinhaber: OSRAM AG, 81543 München (DE); Osram Opto Semiconductors Gmbh, 93055 Regensburg (DE)
(72) Erfinder: Braune, Bert, 93173, Wenzenbach (DE); Brunner, Herbert, 93161, Sinzing (DE); Fiedler, Tim, 81369, München (DE); Jermann, Frank, 86343, Königsbrunn (DE); Zachau, Martin, 82269, Geltendorf (DE)

(56) Entgegenhaltungen:
- US-A1- 2002 043 926
- US-B1- 6 255 670
- KREVEL VAN J W H ET AL: "LUMINESCENCE PROPERTIES OF TERBIUM-, CERIUM-, OR EUROPIUM-DOPED ALPHA-SIALON MATERIALS", JOURNAL OF SOLID STATE CHEMISTRY, ORLANDO, FL, US, Bd. 165, Nr. 1, April 2002 (2002-04), Seiten 19-24, XP001157540, ISSN: 0022-4596
- XIE R-J ET AL: "PREPARATION AND LUMINESCENCE SPECTRA OF CALCIUM- AND RARE-EARTH (R = EU, TB, AND PR)-CODOPED ALPHA-SIALON CERAMICS", JOURNAL OF THE AMERICAN CERAMIC SOCIETY, AMERICAN CERAMIC SOCIETY. COLUMBUS, US, Bd. 85, Nr. 5, 1. Oktober 2000 (2000-10-01), Seiten 1229-1234, XP001151981, ISSN: 0002-7820

## Beschreibung

### Technisches Gebiet

Diese Anmeldung steht in engem Zusammenhang mit folgenden Anmeldungen: 2003P14657, 2003P14656, und 2003P14655.

Die Erfindung geht aus von einer grün emittierenden LED. Unter grün emittierend wird hier insbesondere eine Emission im Bereich um 560 m verstanden.

### Stand der Technik

Üblicherweise wird eine farbig emittierende LED durch einen entsprechend angepassten Chip realisiert. Im Falle einer grünen Emission ist dies jedoch problematisch, da etablierte Techniken wie ein InGaN-Chip (blau) oder ein InGaA1P-Chip (rot) wegen mangelnder Effizienz nicht eingesetzt werden können. Stattdessen müssen Sonderlösungen verwendet werden. Beispiele für derartige Sonderlösungen sind in EP 584 599, DE 198 06 536 und DE 100 24 924 zu finden. Sie weisen jedoch immer noch eine relativ geringe Effizienz auf. Außerdem zeigen sie eine relativ starke Temperaturdrift des Farborts der Emission.

Als Alternative sind daher grün emittierende LEDs auf Basis von Lumineszenzkonversions-LEDs entwickelt worden. Beispiele finden sich in WO 01/89001 und EP 1 150 361. Aber bis jetzt ist dabei keine höhere Effizienz erzielt worden als bei direkt emittierenden LEDs. Dies liegt an den bisher dafür zur Verfügung stehenden Leuchtstoffen (BAM-Derivate und Sulfide) und deren Anregbarkeit.

Leuchtstoffe des Typs Oxinitridosilikat sind an sich unter der Kurzformel MSiON bekannt; siehe beispielsweise "On new rare-earth doped M-Si-Al-O-N materials" , J. van Krevel, TU Eindhoven 2000, ISBN 90-386-2711-4, Kap. 6. sie sind mit Tb dotiert. Emission wir erreicht bei Anregung durch 365 nm oder 254 nm.

In der US 2002/0043926 wird ein mit Eu²⁺ aktiviertes Oxinitrid Ca-Al-Si-O-N beschrieben.

Ein neuartiger Leuchtstoff ist aus der noch unveröffentlichten EP-PA 02 021 117.8 (Docket 2002P15736) bekannt. Er besteht aus Eu- oder Eu,Mn-koaktiviertem Oxinitridosilikat der Formel MSi₂O₂N₂ (M = Ca, Sr, Ba).

### Darstellung der Erfindung

Es ist Aufgabe der vorliegenden Erfindung, eine grün emittierende LED gemäß dem Oberbegriff des Anspruchs 1 bereitzustellen, deren Effizienz möglichst hoch ist. Eine weitere Aufgabe ist die Stabilisierung des Farborts.

Diese Aufgabe wird durch die kennzeichnenden Merkmale des Anspruchs 1 gelöst. Besonders vorteilhafte Ausgestaltungen finden sich in den abhängigen Ansprüchen.

Bisher gibt es keinen grün emittierenden Leuchtstoff hoher Effizienz, der gleichzeitig unempfindlich gegen äußere Einflüsse ist und in einer LED nutzbar wäre.

Erfindungsgemäß wird ein Leuchtstoff vorgeschlagen, der ein Oxinitridosilikat der Formel MSi₂O₂N₂ (M = Ca, Sr, Ba) darstellt, das mit zweiwertigem Eu aktiviert ist, unter evtl. weiterer Zugabe von Mn als Koaktivator, wobei der Leuchtstoff überwiegend oder allein, also mit einem Anteil von mehr als 50 % des Leuchtstoffs, aus der HT-Phase besteht. Diese HT-Modifikation zeichnet sich dadurch aus, dass sie breitbandig anregbar aus, nämlich in einem weiten Bereich von 200 bis 480 nm, dass sie eine extrem hohe Stabilität gegen äußere Einflüsse besitzt, also bei 150°C keine messbare Degradation zeigt, und dass sie eine extrem gute Farbortstabilität unter wechselnden Bedingungen zeigt (zwischen 20 und 100 °C nur geringe Drift nachweisbar). Dieser Leuchtstoff wird im folgenden oft Sr-Sion:Eu genannt.

Bei der Herstellung des neuartigen Leuchtstoffs kommt es vor allem auf eine hohe Temperatur an, der Synthesebereich liegt bei 1300 bis 1600 °C. Ein anderer bestimmender Faktor ist die Reaktivität der Ausgangskomponenten. Diese sollte möglichst hoch sein.

Insbesondere kann dieser Leuchtstoff von einer LED, vor allem vom Typ InGaN, effizient angeregt werden.

Der aus EP-PA 02 021 117.8 bekannte Leuchtstoff MSi₂O₂N₂:Eu (M = Ca, Sr, Ba) ist im Falle der Sr-dominierten Ausführungsform mit M= Sr oder M =

Sr_{(1-x-y)}Ba_{y}Caₓ mit x+y < 0,5 , im folgenden Sr-Sion genannt, nur schwer beherrschbar. Obwohl einzelne Versuchsbedingungen hervorragende Ergebnisse liefern, fehlt bislang eine Richtschnur, um zuverlässig gewünschte Ergebnisse zu erhalten. Hinzu kommt eine gewisse Neigung, dass sich bei hoher Temperaturbelastung die Effizienz des Leuchtstoffs verringert und der Farbort zu stark variiert.

Überraschenderweise hat sich nun gezeigt, dass sich die beiden Phasen in ihrer Eignung als Leuchtstoff grundlegend unterscheiden. Während die NT-Phase als Eudotierter Leuchtstoff nur bedingt zu gebrauchen ist, und eher orange-rot emittiert, zeigt die HT-Phase eine hervorragende Eignung als Leuchtstoff, der grün emittiert. Häufig liegt eine Mischung beider Modifikationen vor, die breitbandig beide Emissionen erkennen lässt. Gewünscht ist daher, die HT-Phase möglichst rein, mit mindestens 50 % Anteil, bevorzugt mindestens 70 %, besonders bevorzugt mindestens 85% Anteil herzustellen.

Dafür ist ein Glühprozess erforderlich, der bei mindestens 1300 °C, aber nicht mehr als 1600 °C durchgeführt wird. Bevorzugt ist ein Temperaturbereich von etwa 1450 bis 1580 °C, da bei geringerer Temperatur zunehmend NT-Phase entsteht und bei höherer Temperatur der Leuchtstoff zunehmend schlechter verarbeitbar ist, und ab etwa 1600 °C als hart gesinterte Keramik oder Schmelze vorliegt. Der optimale Temperaturbereich hängt von der genauen Zusammensetzung und den Eigenschaften der Ausgangsmaterialien ab.

Besonders wichtig für das Herstellen eines effizienten Leuchtstoffs des Typs Sr-Sion ist ein Ansatz der Ausgangsprodukte, der im wesentlichen stöchiometrisch ist unter Verwendung der Grundkomponenten SiO ₂, SrCO ₃ sowie Si ₃ N ₄. Sr steht hier beispielhaft stellvertretend für M. Die Abweichung sollte insbesondere 10 %, bevorzugt 5 %, des idealen stöchiometrischen Ansatzes nicht überschreiten, wobei auch die etwaige Zugabe eines Schmelzmittels, wie es oft üblich ist, dabei eingeschlossen ist. Besonders bevorzugt ist eine maximale Abweichung von 1 %. Hinzu kommt ein Vorläufer für den Europium-Beitrag der Dotierung, der beispielsweise als Oxid Eu ₂ O ₃ realisiert wird. Diese Erkenntnis steht im Gegensatz zu der bisherigen Vorgehensweise, die Grundkomponente SiO ₂ deutlich unterstöchiometrisch zuzugeben. Besonders überraschend ist diese Erkenntnis auch deswegen, weil andere als Leuchtstoff empfohlene Sione wie Ba-Sion gemäß der Lehre von EP-PA 02 021 117.8 gerade im SiO ₂-Unterschuss hergestellt werden sollen.

Ein entsprechender Ansatz für das Sr-Sion MSi₂O₂N₂ verwendet daher 11 bis 13 Gew.-% SiO ₂ , 27 bis 29 Gew.-% Si ₃ N ₄ , Rest SrCO ₃. Ba- und Ca- Anteile an M werden entsprechend als Carbonat zugesetzt. Europium wird entsprechend der gewünschten Dotierung, beispielsweise als Oxid oder Fluorid, als Ersatz für SrCO ₃ zugesetzt. Der Ansatz MSi₂O₂N₂ meint dabei auch etwaige Abweichungen von der exakten Stöchiometrie, soweit sie hinsichtlich der Ladungserhaltung ausgeglichen sind.

Als besonders günstig hat sich erwiesen, dass die Ausgangskomponenten des Wirtsgitters, insbesondere Si ₃ N ₄ , möglichst hohe Reinheit besitzen. Besonders bevorzugt ist daher Si ₃ N ₄ , das aus der flüssigen Phase, ausgehend beispielsweise von Siliziumtetrachlorid, synthetisiert ist. Als kritisch hat sich insbesondere die Verunreinigung mit Wolfram und Kobalt, erwiesen. Hier sollte die Verunreinigung möglichst gering sein, insbesondere sollte sie jeweils kleiner 100 ppm, insbesondere kleiner 50 ppm, sein, bezogen auf diese Vorläufersubstanzen. Des weiteren ist eine möglichst hohe Reaktivität vorteilhaft, sie lässt sich durch die reaktive Oberfläche (BET) quantifizieren. Diese sollte mindestens 6 m²/g betragen, vorteilhaft mindestens 8 m²/g. Auch die Verunreinigung an Aluminium und Calcium, bezogen auf diese Vorläufersubstanz Si ₃ N ₄, sollte möglichst unter 100 ppm liegen.

Bei Abweichung von der oben angegebenen Verfahrensführung in bezug auf stöchiometrischen Ansatz und Temperaturführung entstehen als unerwünschte Fremdphasen in zunehmendem Maße Nitridosilikate MxSiyNz wie etwa M2Si5N8, wenn die SiO₂-Zugabe zu niedrig angesetzt wird, so dass ein Stickstoffüberschuss entsteht. Obwohl diese Verbindung an sich ein bemerkenswerter Leuchtstoff ist, ist sie in Zusammenhang mit der Synthese des Sr-Sions genauso wie andere Nitridosilikate äußerst störend, weil diese Fremdphasen die grüne Strahlung des Sr-Sions absorbieren und evtl. in die bekannte rote Strahlung der Nitridosilikate umwandeln. Umgekehrt entstehen bei zu hoher SiO ₂-Zugabe Sr-Silikate wie beispielsweise Sr₂SiO₄ weil ein Sauerstoffüberschuss entsteht. Beide Fremdphasen absorbieren die nutzbare grüne Emission oder führen zumindest zu Gitterdefekten wie Leerstellen, die die Effizienz des Leuchtstoffs stark beeinträchtigen. Als Anhaltspunkt dient die Richtschnur, dass der Anteil der Fremdphasen möglichst unter 15 %, bevorzugt sogar unter 5 %, liegen soll. Dies korrespondiert im XRD-Spektrum des synthetisierten Leuchtstoffs mit der Forderung, dass beim XRD-Ablenkwinkel 2 Θ im Bereich 25 bis 32° die Intensität aller Fremdphasenpeaks kleiner als 1/3, bevorzugt kleiner als ¼, besonders bevorzugt kleiner als 1/5, der Intensität des die HT-Modifikation kennzeichnenden Hauptpeaks bei etwa 31,8° sein soll. Dies gilt vor allem für die Fremdphasen vom Typ SrxSiyNz, insbesondere Sr2Si5N8.

Im Falle einer optimierten Verfahrensführung lässt sich zuverlässig eine Quanteneffizienz von 80 bis deutlich über 90 % erzielen. Dagegen wird bei unspezifischer Verfahrensführung die Effizienz typisch im Bereich von höchstens 50 bis 60 % Quanteneffizienz liegen.

Erfindungsgemäß lässt sich somit ein Leuchtstoff herstellen, der ein Oxinitridosilikat der Formel MSi₂O₂N₂ (M = Ca, Sr, Ba) darstellt, das mit zweiwertigem Eu aktiviert ist, unter evtl. weiterer Zugabe von Mn als Koaktivator, wobei der Leuchtstoff überwiegend oder allein, also zu mehr als 50 % des Leuchtstoffs, bevorzugt zu mehr als 85% des Leuchtstoffs, aus der HT-Phase besteht. Diese HT-Modifikation zeichnet sich dadurch aus, dass sie breitbandig anregbar ist, nämlich in einem weiten Bereich von 50 bis 480 nm, insbesondere 150 bis 480 nm, besonders bevorzugt von 250 bis 470 nm, dass er eine extrem hohe Stabilität gegen äußere Einflüsse besitzt, also bei 150°C an Luft keine messbare Degradation zeigt, und dass er eine extrem gute Farbortstabilität unter wechselnden Bedingungen zeigt. Weitere Pluspunkte sind seine geringe Absorption im Roten, was besonders bei Leuchtstoffmischungen vorteilhaft ist. Dieser Leuchtstoff wird im folgenden oft Sr-Sion:Eu genannt. Ein Überwiegen der HT-Modifikation ist u.a. daran erkennbar, dass der kennzeichnende Peak der NT-Modifikation im XRD-Spektrum bei etwa 28,2 ° eine Intensität von weniger als 1:1, bevorzugt weniger als 1:2, im Vergleich zum Peak mit höchster Intensität aus der Dreiergruppe der Reflexe der HT-Modifikation, die im XRD-Spektrum bei 25 bis 27° liegen, aufweist. Die hier aufgeführten XRD-Spektren beziehen sich jeweils auf eine Anregung durch die bekannte Cu-K_{α} Linie.

Bei gleicher Aktivatorkonzentration zeigt dieser Leuchtstoff ein anderes Emissionsverhalten als die NT-Variante gleicher Stöchiometrie. Die Halbwertsbreite der HT-Variante ist im Falle der optimierten HT-Variante wesentlich geringer als bei der einfachen fremdphasen- und defekthaltigen Mischung und liegt im Bereich 70 bis 80 nm, während die einfache Fremdphasen- bzw. defekthaltige Mischung eine Halbwertsbreite von etwa 110 bis 120 nm zeigt. Die dominante Wellenlänge ist bei der HT-Modifikation generell kürzer, typisch 10 bis 20 nm kürzer, als bei einer deutlich fremdphasenhaltigen Probe. Hinzu kommt, dass die Effizienz der hochreinen HT Modifikation typisch um mindestens 20 % höher, teilweise deutlich noch höher, als bei der NT-dominierten oder hoch fremdphasenhaltigen Mischung liegt.

Ein kennzeichnendes Merkmal eines ausreichend geringen Anteils der NT-Modifikation und Fremdphasen ist eine Halbwertsbreite (FWHM) der Emission von weniger als 90 nm. Denn je geringer der Anteil an Fremdphasen, desto geringer ist der Anteil der spezifischen orange-roten Emission der fremdphasenreichen Modifikation, insbesondere der Nitridosilikat-Fremdphasen Sr-Si-N-Eu wie vor allem Sr2Si5N8:Eu.

Hilfreich zur Charakterisierung sind neben der verringerten Halbwertsbreite die oben angegebenen typischen Reflexe im XRD-Spekrum, die die andere Kristallstruktur verdeutlichen.

Der vorherrschende Peak im XRD-Spektrum der HT-Modifikation ist der Peak bei etwa 31.7°. weitere prominente Peaks sind die drei Peaks etwa gleicher Intensität zwischen 25 und 27° (25,3 und 26,0 und 26,3°), wobei der Peak mit kleinster Ablenkung der intensivste ist. ein weiterer intensiver Peak ist 12,6°.

Dieser Leuchtstoff ist vor allem grün emittierend mit einer Dominanzwellenlänge im Bereich 555 bis 565 nm.

Auch eine geringfügige Beimengung der Gruppe AIO als Ersatz der Gruppe SiN im Molekül des Oxinitridosilikats der Formel MSi₂O₂N₂ ist möglich, insbesondere bis maximal 30 % des SiN-Anteils.

Beide Phasen des Sr-Sion:Eu können analog zu den zwei strukturell unterschiedlichen Wirtsgittermodifikationen kristallisieren und jeweils über die Ansatzstöchiometrie SrSi2O2N2:Eu hergestellt werden. Geringe Abweichungen von dieser Stöchiometrie sind möglich. Die mit Eu dotierten Wirtsgitter lumineszieren überraschenderweise beide bei Anregung im Blauen oder UV, allerdings je nach Wirtsgittermodifikation mit anderer Emissionsfarbe. Die NT-Modifikation zeigt eine orangefarbene Emission, die HT-Modifikation eine grüne Emission bei etwa λ_{dom} = 560 nm mit prinzipiell deutlich höherer Effizienz. Je nach Dotiergehalt und Dotiermaterial (Eu oder Eu, Mn) sowie den relativen Anteilen der HT- und NT-Modifikation lässt sich eine gewünschte Eigenschaft des Leuchtstoffs genau einstellen.

Ein Vorzug der HT-Phase ist die über einen sehr weiten Spektralbereich gleichmäßig gute Anregbarkeit bei nur wenig variierender Quanteneffizienz.

Außerdem hängt die Lumineszenz der HT-Modifikation in einem weiten Temperaturbereich nur schwach von der Temperatur ab. Damit ist erstmals ein grün emittierender Leuchtstoff, bevorzugt für LED-Anwendungen, gefunden, der ohne besondere Maßnahmen zur Stabilisierung auskommt. Dies zeichnet ihn besonders gegen die bisher als aussichtsreichste Kandidaten angesehenen Leuchtstoffe für diese Aufgabe aus, nämlich Thiogallat-Leuchtstoffe oder Chlorosilikate.

Die Sionverbindungen mit M = (Sr,Ba), bevorzugt ohne Ba oder mit Ba-Anteil bis zu 10 %, stellen effiziente Leuchtstoffe mit einem weiten Bereich der Emissionsmaxima dar. Diese liegen meist kurzwelliger als bei reinem Sr-Sion, bevorzugt zwischen 520 und 565 nm. Der erreichbare Farbraum lässt sich außerdem durch geringe Beigaben (bevorzugt bis 30 mol-%) an Ca und/oder Zink erweitern; dadurch werden die Emissionsmaxima eher in den langwelligeren Bereich, verglichen mit reinem Sr-Sion, verschoben, sowie durch partiellen Ersatz (bis 25 mol-%) von Si durch Ge und/oder Sn.

Eine weitere Ausführungsform ist die Teilsubstitution von M, insbesondere Sr, durch drei- oder einwertige Ionen wie La3+ oder Li+. Bevorzugt ist ein Anteil dieser Ionen von maximal 20 mol-% des M.

Überraschend ist nun mit dem Sr-Sion der HT-Phase ein Leuchtstoff gefunden, der sich exakt auf eine Emission der Wellenlänge λ_{dom} = 560 nm (Dominanzwellenlänge) einstellen lässt. Der Leuchtstoff wandelt das Licht einer blauen oder UV-LED mit einer Quanteneffizienz von deutlich mehr als 80 % um. Die lumenbewertete Effizienz ist vergleichbar mit der typischer weißer LEDs auf YAG:Ce-Basis. Damit ist eine "pure green" Konversions-LED fast eine Größenordnung effizienter als die reine Halbleitervariante.

Als weiterer Vorteil ist anzusehen, dass die Emissionsfarbe der Lumineszenzkonversions-LED praktisch unabhängig von der Betriebstemperatur ist, damit kann die LED gut bei unterschiedlichen Außentemperaturen betriebe werden und ist farbortstabil dimmbar.

Die Erfindung betrifft weiterhin ein Beleuchtungssystem mit LEDs wie oben beschrieben, wobei das Beleuchtungssystem weiterhin elektronische Komponenten enthält. diese vermitteln beispielsweise die Dimmbarkeit. Eine weitere Aufgabe der Elektronik ist die Ansteuerung einzelner LEDs oder auch Gruppen von LEDs. Diese Funktionen können durch vorbekannte elektronische Elemente realisiert sein.

### Figuren

Im folgenden soll die Erfindung anhand zweier Ausführungsbeispiele näher erläutert werden. Es zeigen:
- Figur 1: ein Emissionsspektrum eines ersten Oxinitridosilikats;
- Figur 2: das Reflektionsspektrum dieses Nitridosilikats;
- Figur 3: ein Halbleiterbauelement, das als Lichtquelle für grünes Licht als Lumineszenzkonversions-LED dient;
- Figur 4: das Farbdiagramm mit einem nutzbaren Bereich für reines Grün. als Viereck eingezeichnet.
- Figur 5: zeigt die spektrale Verteilung der Lumineszenzkonversions-LED.

### Beschreibung der Zeichnungen

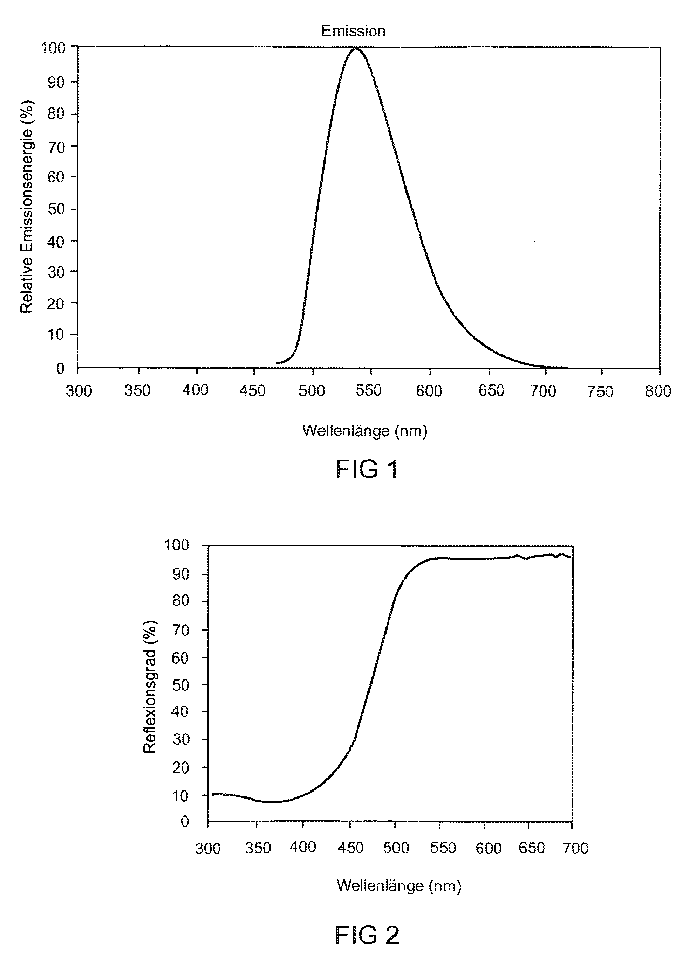

Ein konkretes Beispiel für den erfindungsgemäßen Leuchtstoff ist in Figur 1 gezeigt. Es handelt sich um die Emission des Leuchtstoffs SrSi₂N₂O₂:(5 % Eu²⁺) in HT-Modifikation, bei dem der Eu-Anteil 5 mol-% der von Sr besetzten Gitterplätze ausmacht. Das Emissionsmaximum liegt bei 540 nm, die mittlere Wellenlänge λdom bei 558 nm. Der Farbort ist x=0,357; y=0,605. Die Anregung erfolgte hier bei 460 nm. die FWHM ist 76 nm. Die Quanteneffizienz liegt bei etwa 90 %. Der Farbort ist x = 0,357, y = 0,605.

Figur 2 zeigt das diffuse Reflexionsspektrum dieses Leuchtstoffs. Es zeigt ein ausgeprägtes Minimum im Bereich unter 440 nm, das somit die gute Anregbarkeit in diesem Bereich demonstriert.

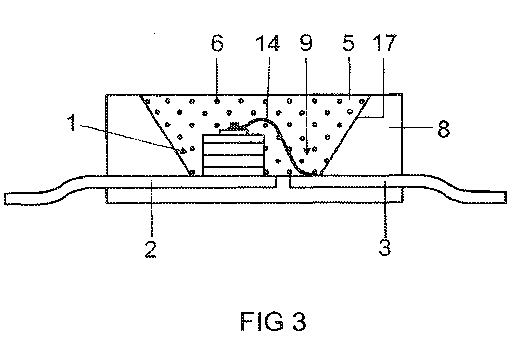

Der Aufbau einer Lichtquelle für weißes Licht ist in Figur 3 explizit gezeigt. Die Lichtquelle ist ein Halbleiterbauelement mit einem Chip 1 des Typs InGaN mit einer Peakemissionswellenlänge im UV von beispielsweise 405 nm, bis zu 430 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Epoxidgießharz (80 bis 90 Gew.-%) und Leuchtstoffpigmente 6 (weniger als 20 Gew.-%) enthält. Die Ausnehmung hat eine Wand 17, die als Reflektor für die Primär- und Sekundärstrahlung vom Chip 1 bzw. den Pigmenten 6 dient. Die Primärstrahlung der UV-LED wird vollständig vom Leuchtstoff in grün konvertiert. Der verwendete Leuchtstoff ist das oben beschriebene Oxinitridosilikat.

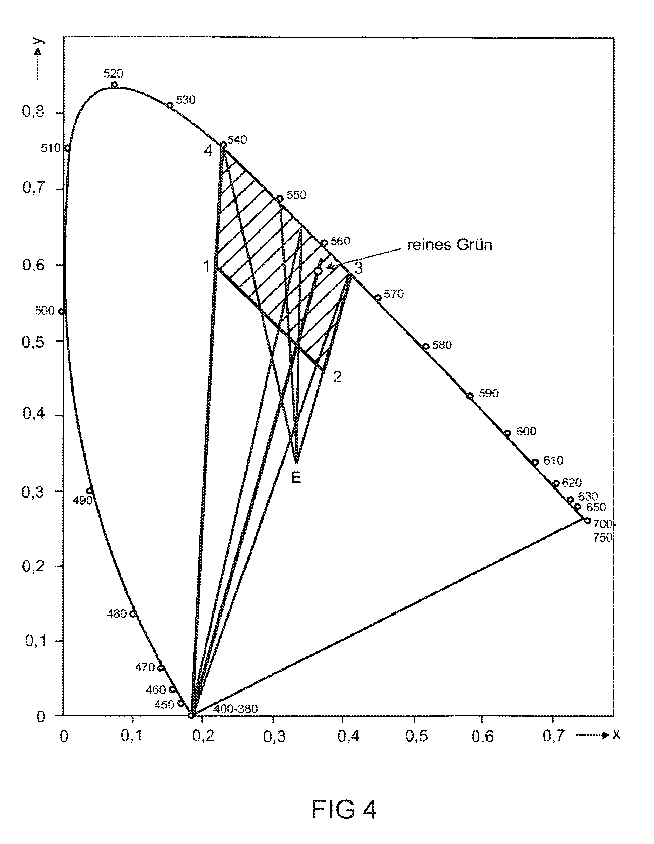

Als nutzbarer reingrüner Bereich ("pure green"), der hier angestrebt ist, wird ein Bereich angesehen der im Farbdiagramm in etwa durch ein Viereck mit den Ecken
(1): x/y = 0,22/0,595;
(2): x/y = 0,37/0,46;
(3): x/y = 0,41/0,59 und
(4): x/y = 0,225/0,755
bestimmt ist, siehe dazu Figur 4.

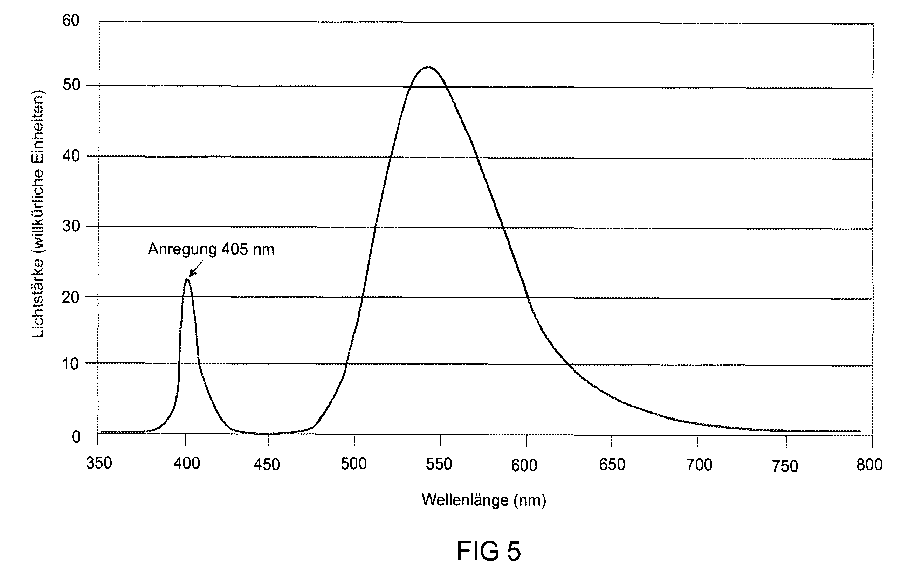

Figur 5 zeigt die spektrale Verteilung der Emission einer Lumineszenzkonversions-LED auf Basis einer UV-primär emittierenden LED mit Peak bei 405 nm.

## Patentansprüche

1. Grün emittierende LED, die als Lumineszenzkonversions-LED ausgeführt ist, bestehend aus einer Primär-Strahlungsquelle, die ein Chip ist, der im UV oder blauen Strahlungsbereich emittiert, und einer davor angeordneten Schicht eines Leuchtstoffs, die die Strahlung des Chip **vollständig** in grünes Licht der dominanten Wellenlänge λ_{dom} = 550 bis 570 nm konvertiert, **dadurch gekennzeichnet, dass** der Leuchtstoff der Klasse der Oxinitridosilikate angehört, mit einem Kation M und der grundsätzlichen Formel M_{(1-c)}Si₂O₂N₂:D_{c}, wobei D eine Dotierung mit zweiwertigem Europium bedeutet **und wobei der Anteil c der Dotierung am Kation im Bereich 0,1 bis 20 Mol.-% liegt,** und wobei M als Bestandteil Sr umfasst und M = Sr allein oder M = Sr_{(1-x-y)}Ba_{y}Caₓ mit 0 ≤ x+y < 0,5 verwendet wird, und wobei das Oxinitridosilikat vollständig oder überwiegend aus der hochtemperaturstabilen Modifikation HT besteht, **wobei LED und Leuchtstoff eine Emission im x-y-Farbdiagramm erzielen, die einen reingrünen Bereich mit folgenden Ecken aufspannt:**
**x/v = 0,22/0,595;**
**x/v = 0,37/0,46;**
**x/v = 0,41/0,59 und**
**x/v = 0,225/0,755.**

2. LED nach Anspruch 1, **dadurch gekennzeichnet, dass** der Anteil des Eu zwischen 0,1 und 20 mol% von M ausmacht.

3. LED nach Anspruch 1, **dadurch gekennzeichnet, dass** Sr als M den überwiegenden Anteil stellt und ein Teil von M, insbesondere bis zu 30 mol-%, durch Ba und/oder Ca ersetzt ist.

4. LED nach Anspruch 1, **dadurch gekennzeichnet, dass** ein Teil von M, insbesondere bis zu 30 mol%, durch Li und/oder La und/oder Zn ersetzt ist.

5. LED nach Anspruch 1, **dadurch gekennzeichnet, dass** ein Teil der Gruppe SiN im Oxinitridosilikat der Formel MSi₂O₂N₂, insbesondere bis zu 30 mol%, durch die Gruppe AIO ersetzt ist.

6. LED nach Anspruch 1, **dadurch gekennzeichnet, dass** ein Teil von Eu, insbesondere bis zu 30 mol%, durch Mn ersetzt ist.

7. LED nach Anspruch 1, **dadurch gekennzeichnet, dass** die primäre Emission eine Peakwellenlänge im Bereich 340 bis 430 nm, insbesondere mindestens 380 nm, hat.

8. LED nach Anspruch 1, **dadurch gekennzeichnet, dass** die grüne Emission eine dominante Wellenlänge im Bereich 556 bis 564 nm hat.

9. LED nach Anspruch 1, **dadurch gekennzeichnet, dass** die primäre Strahlung vollständig konvertiert wird.

10. LED nach Anspruch 1, **dadurch gekennzeichnet, dass** der Chip ein InGaN-Chip mit einer Peakemissionswellenlänge im Bereich von 430 bis 465 nm ist.

11. LED nach Anspruch 1, **dadurch gekennzeichnet, dass** die LED dimmbar ist.

## Claims

1. Green-emitting LED which is designed as a luminescence conversion LED, comprising a primary radiation source, which is a chip emitting in the UV or blue radiation region, and a layer of a phosphor which is arranged in front of the primary radiation source and completely converts the radiation of the chip into green light of dominant wavelength λ_{dom} = 550 to 570 nm, **characterized in that** the phosphor belongs to the class of the oxynitridosilicates, having a cation M and the empirical formula M_{(1-c)}Si₂O₂N₂:D_{c}, where D denotes a doping with divalent europium and where the fraction c of the doping in the cation is in the range from 0.1 to 20 mol% and where M comprises Sr as a constituent and M = Sr alone or M = Sr_{(1-x-y)}Ba_{y}Caₓ with 0 ≤ x+y < 0.5 is used, the oxynitridosilicate completely or predominantly comprising the high-temperature-stable modification HT, where LED and phosphor achieve an emission in the x-y-color diagram which covers a pure green region having the following corners:
x/y = 0.22/0.595;
x/y = 0.37/0.46;
x/y = 0.41/0.59 and
x/y = 0.225/0.755.

2. LED according to Claim 1, **characterized in that** the Eu fraction makes up between 0.1 and 20 mol% of M.

3. LED according to Claim 1, **characterized in that** Sr represents the majority of M and a proportion of M, in particular up to 30 mol%, is replaced by Ba and/or Ca.

4. LED according to Claim 1, **characterized in that** a proportion of M, in particular up to 30 mol%, is replaced by Li and/or La and/or Zn.

5. LED according to Claim 1, **characterized in that** part of the SiN group in the oxynitridosilicate of formula MSi₂O₂N₂, in particular up to 30 mol%, is replaced by the AlO group.

6. LED according to Claim 1, **characterized in that** a proportion of Eu, in particular up to 30 mol%, is replaced by Mn.

7. LED according to Claim 1, **characterized in that** the primary emission has a peak wavelength in the range from 340 to 430 nm, in particular at least 380 nm.

8. LED according to Claim 1, **characterized in that** the green emission has a dominant wavelength in the range from 556 to 564 nm.

9. LED according to Claim 1, **characterized in that** the primary radiation is completely converted.

10. LED according to Claim 1, **characterized in that** the chip is an InGaN chip with a peak emission wavelength in the range from 430 to 465 nm.

11. LED according to Claim 1, **characterized in that** the LED is dimmable.

## Revendications

1. LED émettant une lumière verte, exécutée sous forme de LED à conversion de luminescence, se composant d'une source de rayonnement primaire, qui est une puce émettant dans le domaine de l'ultraviolet ou du bleu, et d'une couche d'une substance luminescente placée devant, qui convertit le rayonnement de la puce entièrement en lumière verte de longueur d'onde dominante λ_{dom} = 550 à 570 nm, **caractérisée en ce que** la substance luminescente appartient à la classe des oxynitridosilicates, avec un cation M et la formule fondamentale M_{(1-c)}Si₂O₂N₂:D_{c}, où D signifie un dopage avec de l'europium bivalent et où la proportion c du dopage au niveau du cation est comprise entre 0,1 et 20 mol%, et où M comprend comme constituant Sr et M = Sr seul ou M = Sr_{(1-x-y)}Ba_{y}Caₓ avec 0 ≤ x+y < 0,5 est utilisé, et où l'oxynitridosilicate est composé entièrement ou majoritairement de la modification HT stable à haute température, ladite LED et ladite substance luminescente obtenant dans le diagramme chromatique xy une émission définissant une zone dans le domaine du vert pur avec les points suivants :
x/y = 0,22/0,595 ;
x/y = 0,37/0,46 ;
x/y = 0,41/0,59 et
x/y = 0,225/0,755.

2. LED selon la revendication 1, **caractérisée en ce que** la proportion de l'Eu représente entre 0,1 et 20 mol% de M.

3. LED selon la revendication 1, **caractérisée en ce que** Sr en tant que M représente la proportion majoritaire et **en ce qu'**une partie de M, en particulier jusqu'à 30 mol%, est substituée par Ba et/ou Ca.

4. LED selon la revendication 1, **caractérisée en ce qu'**une partie de M, en particulier jusqu'à 30 mol%, est substituée par Li et/ou La et/ou Zn.

5. LED selon la revendication 1, **caractérisée en ce qu'**une partie du groupe SiN présent dans l'oxynitridosilicate de formule MSi₂O₂N₂, en particulier jusqu'à 30 mol%, est substituée par le groupe AlO.

6. LED selon la revendication 1, **caractérisée en ce qu'**une partie d'Eu, en particulier jusqu'à 30 mol%, est substituée par Mn.

7. LED selon la revendication 1, **caractérisée en ce que** l'émission primaire a un pic de longueur d'onde compris entre 340 et 430 nm, en particulier d'au moins 380 nm.

8. LED selon la revendication 1, **caractérisée en ce que** l'émission de lumière verte a une longueur d'onde dominante comprise entre 556 et 564 nm.

9. LED selon la revendication 1, **caractérisée en ce que** le rayonnement primaire est entièrement converti.

10. LED selon la revendication 1, **caractérisée en ce que** la puce est une puce InGaN avec un pic de longueur d'onde d'émission compris entre 430 et 465 nm.

11. LED selon la revendication 1, **caractérisée en ce que** la LED est à intensité lumineuse variable.
